# EUROPEAN PATENT APPLICATION

(11) **EP 4 546 996 A1**
(43) Date of publication of application: **30.04.2025**
(21) Application number: 24150062.8
(22) Date of filing: 02.01.2024
(51) Int. Cl.: H10N 10/10, H10N 10/13

(54) **THERMOELECTRIC POWER GENERATION SYSTEM**

(30) Priority: 26.10.2023 CN 202311397861
(71) Applicant: Ningbo Baogong Electrical Appliance Co., Ltd., Cixi City, Zhejiang Province, 315000 (CN)
(72) Inventor: JIANG, Xueli, Cixi City, Zhejiang Province,, 315000 (CN); ZHOU, Junshu, Cixi City, Zhejiang Province,, 315000 (CN); LIAO, Yangsheng, Cixi City, Zhejiang Province,, 315000 (CN); YE, Longbiao, Cixi City, Zhejiang Province,, 315000 (CN)
(74) Representative: Viering, Jentschura & Partner mbB Patent- und Rechtsanwälte

(57) **Abstract**

The present invention discloses a thermoelectric power generation system, including: a heat absorption component, configured to absorb heat, where at least a first contact surface is formed on the heat absorption component; a heat dissipation component, configured to dissipate heat, where at least a second contact surface is formed on the heat dissipation component; and a thermoelectric power generation sheet, where the thermoelectric power generation sheet has at least a first surface and a second surface, the thermoelectric power generation sheet is capable of generating electric power based on at least a temperature difference between the first surface and the second surface, the first surface is in contact with the first contact surface of the heat absorption component, and the second surface is in contact with the second contact surface of the heat dissipation component. According to the present invention, a heater can have characteristics of being energy-saving and environmentally friendly, and convenience of using the heater can also be improved.

## Description

### TECHNICAL FIELD

The present invention relates to the field of heater technologies, and in particular, to a thermoelectric power generation system for a heater.

### BACKGROUND

A combustion heater in the conventional technology mainly generates heat by burning fuel. The combustion heater is used in a cold prevention and heating apparatus, and has characteristics of being lightweight and flexible. The combustion heater is widely used in industrial and household fields. The combustion heater heats air through combustion, to generate warm air. However, during use, the warm air is usually discharged to specified space by using a blowing apparatus, and power is supplied to the blowing apparatus in the conventional technology usually by using electric power. Therefore, the blowing apparatus needs to be connected to a power supply through a wire to provide electric power for the blowing apparatus. However, the blowing apparatus cannot be directly connected to the power supply in many cases due to constraints of a usage environment, which makes it inconvenient to use the heater.

### SUMMARY

The present invention provides a thermoelectric power generation system, which can be energy-saving and environmentally friendly and make it more convenient to use a heater.

To resolve the foregoing technical problem, the present invention provides a thermoelectric power generation system, including:
a heat absorption component, configured to absorb heat, where at least a first contact surface is formed on the heat absorption component;
a heat dissipation component, configured to dissipate heat, where at least a second contact surface is formed on the heat dissipation component;
a thermoelectric power generation sheet, where the thermoelectric power generation sheet has at least a first surface and a second surface, the thermoelectric power generation sheet is capable of generating electric power based on at least a temperature difference between the first surface and the second surface, the first surface is in contact with the first contact surface of the heat absorption component, and the second surface is in contact with the second contact surface of the heat dissipation component; and
an installation partition, where the heat dissipation component is connected to the installation partition, the heat absorption component is connected to the heat dissipation component, the heat dissipation component is located on one side of the installation partition, and the heat absorption component is located on the other side of the installation partition.

According to the foregoing technical solution, preferably, the heat absorption component includes a heat absorption baseplate and heat absorption sheets, the plurality of heat absorption sheets are disposed on a front surface of the heat absorption baseplate, the first contact surface is a back surface of the heat absorption baseplate, the heat dissipation component includes a heat dissipation baseplate and heat dissipation sheets, the plurality of heat dissipation sheets are uniformly disposed on a front surface of the heat dissipation baseplate, and the second contact surface is formed on a back surface of the heat dissipation baseplate.

According to the foregoing technical solution, preferably, downward recessed accommodating space is formed on the back surface of the heat dissipation baseplate, a bottom surface of the accommodating space is the second contact surface, the thermoelectric power generation sheet is disposed in the accommodating space, and two side surfaces of the thermoelectric power generation sheet are respectively the first surface and the second surface.

According to the foregoing technical solution, preferably, the second surface of the thermoelectric power generation sheet protrudes from the accommodating space, and is in contact with the back surface of the heat absorption baseplate, and a first specified gap is formed between the back surface of the heat absorption baseplate and the back surface of the heat dissipation baseplate.

According to the foregoing technical solution, preferably, the thermoelectric power generation system further includes a pressing component and a fixing plate, the pressing component is pressed on the heat absorption component, the fixing plate is pressed on the pressing component, a fastener is disposed on the pressing component, the fastener is threadedly connected to the heat dissipation baseplate, and a second specified gap exists between the fixing plate and the back surface of the heat dissipation component.

According to the foregoing technical solution, preferably, the plurality of heat absorption sheets are disposed in parallel, a heat absorption groove is formed between every two adjacent heat absorption sheets, the pressing component includes a pressing strip and a connecting end plate, the pressing strip is located in the heat absorption groove, the connecting end plate is connected to an end portion of the pressing strip, and the fixing plate is pressed on the connecting end plate.

According to the foregoing technical solution, preferably, the pressing strip is an elastic pressing strip.

According to the foregoing technical solution, preferably, an installation opening is formed on the installation partition, a heat absorption channel is formed on one side of the installation partition, a heat dissipation channel is formed on the other side of the installation partition, the heat dissipation baseplate is fastened on the installation partition, the heat absorption sheets penetrate the installation opening, and extend into the heat absorption channel, and the heat dissipation sheets are located in the heat dissipation channel.

According to the foregoing technical solution, preferably, a heat insulation component is disposed between the fixing plate and the back surface of the heat dissipation baseplate.

According to the foregoing technical solution, preferably, a bracket component is disposed on the heat dissipation baseplate, and the bracket component is fastened to the installation partition by using a fastener.

According to the thermoelectric power generation system provided in the present invention, the thermoelectric power generation system includes the heat absorption component, the heat dissipation component, and the thermoelectric power generation sheet. The first contact surface of the heat absorption component is in contact with the first surface of the thermoelectric power generation sheet, and the second contact surface of the heat dissipation component is in contact with the second surface of the thermoelectric power generation sheet. In a working process, the heat absorption component can absorb heat generated by a combustion heater, and the heat dissipation component can dissipate heat. Therefore, the heat absorption component and the heat dissipation component can enable a temperature difference to be formed between the first surface and the second surface of the thermoelectric power generation sheet. The thermoelectric power generation sheet is capable of generating electric power when the temperature difference is formed between the first surface and the second surface, and the electric power generated by the thermoelectric power generation sheet can be provided for a heater appliance apparatus for use. The thermoelectric power generation sheet can convert thermal energy generated by fuel, to implement self-sufficiency of electric power of a heater device, so that convenience of using the heater is greatly improved. In addition, in the embodiments, the heat absorption component can absorb heat generated by combustion. Therefore, the heat absorption component can further enable the temperature difference between the two surfaces of the thermoelectric power generation sheet to be more obvious, and a power generation effect of the thermoelectric power generation sheet is more significant.

The foregoing descriptions are merely an overview of the technical solutions of the present invention. To understand the technical means of the present invention more clearly, the technical means may be implemented according to the content of this specification. In addition, to make the foregoing and other objectives, features, and advantages of the present invention clearer and easier to understand, the following describes specific implementations of the present invention.

### BRIEF DESCRIPTION OF DRAWINGS

FIG. 1 is a schematic diagram of an installation structure of a thermoelectric power generation system according to an embodiment of the present invention;
FIG. 2 is a schematic diagram of an installation structure of another thermoelectric power generation system from another angle according to an embodiment of the present invention;
FIG. 3 is a schematic three-dimensional exploded view of a thermoelectric power generation system according to an embodiment of the present invention;
FIG. 4 is a schematic three-dimensional exploded view of a thermoelectric power generation system from another angle according to an embodiment of the present invention;
FIG. 5 is a sectional view of a thermoelectric power generation system according to an embodiment of the present invention;
FIG. 6 is a schematic diagram of a three-dimensional structure of a heat dissipation component according to an embodiment of the present invention;
FIG. 7 is a schematic diagram of a three-dimensional structure of a heat absorption component according to an embodiment of the present invention; and
FIG. 8 is a schematic diagram of a three-dimensional structure of a pressing component according to an embodiment of the present invention.

In the figures: 110. heat dissipation component; 120. installation partition; 130. heat absorption component; 140. second specified gap; 150. first specified gap; 160. thermoelectric power generation sheet; 170. pressing component; 180. fixing plate; 190. heat insulation component; 1101. heat dissipation baseplate; 1102. accommodating space; 1103. second contact surface; 1104. bracket component; 1105. heat dissipation sheet; 1301. heat absorption baseplate; 1302. heat absorption sheet; 1303. heat absorption groove; 1304. first contact surface; 1701. pressing strip; 1702. connecting end plate; and 1801. fixing plate opening.

### DESCRIPTION OF EMBODIMENTS

To make the objectives, features, and advantages of the present invention clearer and easier to understand, the following clearly and completely describes the technical solutions in the embodiments of the present invention with reference to the accompanying drawings in the embodiments of the present invention. Clearly, the described embodiments are merely some rather than all of the embodiments of the present invention. Based on the embodiments in the present invention, all other embodiments obtained by a person skilled in the art without creative efforts fall within the protection scope of the present invention.

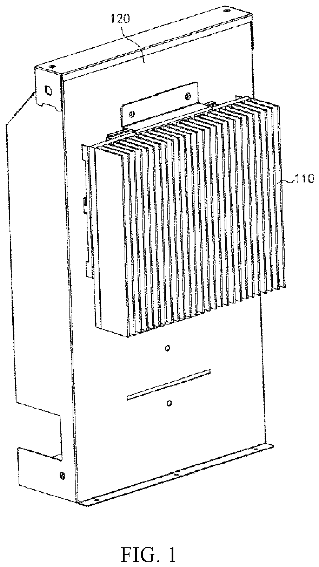

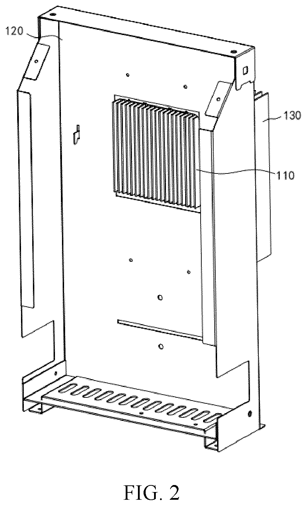

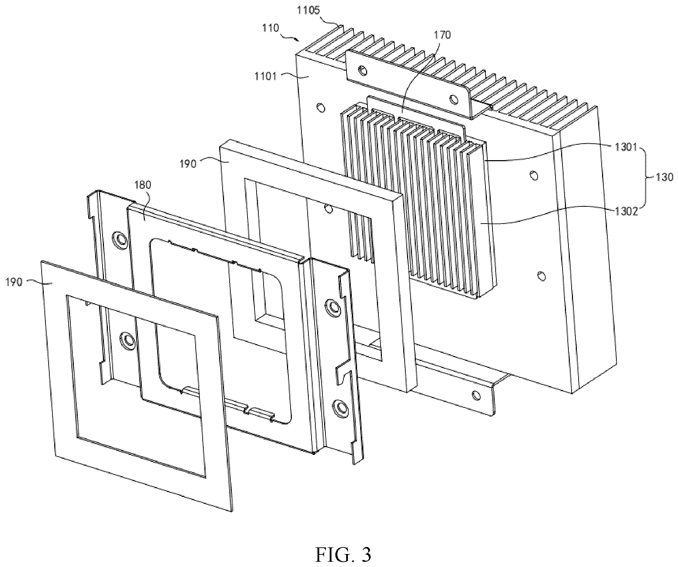

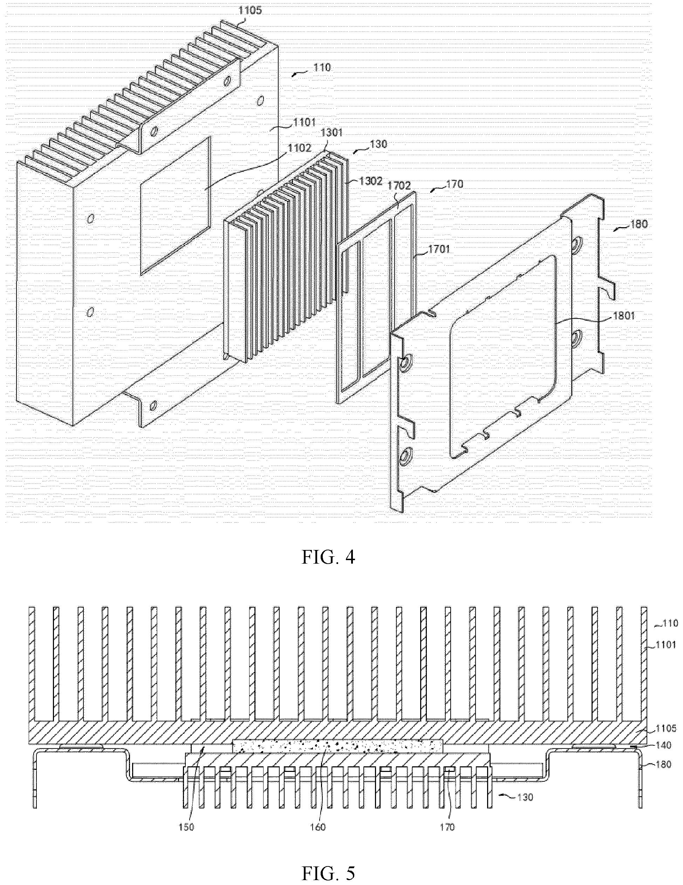

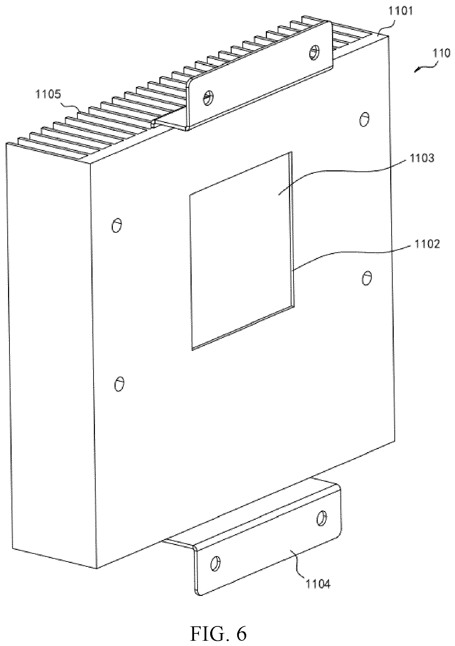

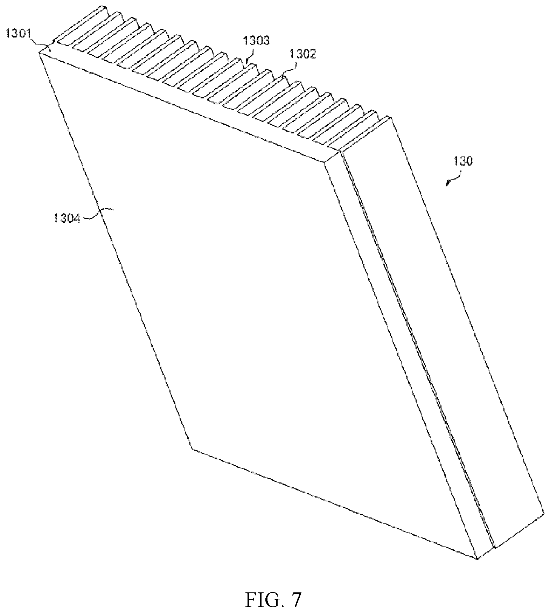

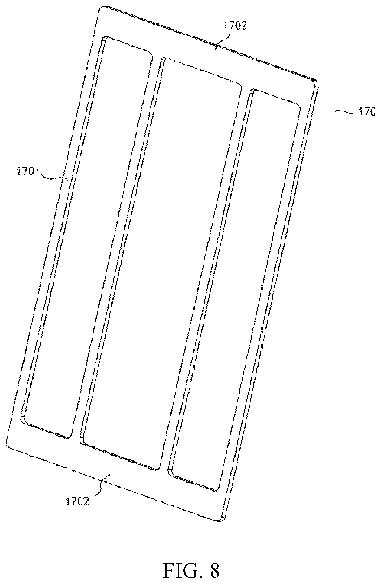

Referring to FIG. 1 to FIG. 8, an embodiment of the present invention provides a thermoelectric power generation system, including:
a heat absorption component 130, configured to absorb heat, where at least a first contact surface 1304 is formed on the heat absorption component 130;
a heat dissipation component 110, configured to dissipate heat, where at least a second contact surface 1103 is formed on the heat dissipation component 110;
a thermoelectric power generation sheet 160, where the thermoelectric power generation sheet 160 has at least a first surface and a second surface, the thermoelectric power generation sheet 160 is capable of generating electric power based on at least a temperature difference between the first surface and the second surface, the first surface is in contact with the first contact surface 1304 of the heat absorption component 130, and the second surface is in contact with the second contact surface 1103 of the heat dissipation component 110; and
an installation partition 120, where the heat dissipation component 110 is connected to the installation partition 120, the heat absorption component 130 is connected to the heat dissipation component 110, the heat dissipation component 110 is located on one side of the installation partition 120, and the heat absorption component 130 is located on the other side of the installation partition 120.

According to the thermoelectric power generation system provided in this embodiment, the thermoelectric power generation system includes the heat absorption component 130, the heat dissipation component 110, and the thermoelectric power generation sheet 160. The first contact surface 1304 of the heat absorption component 130 is in contact with the first surface of the thermoelectric power generation sheet 160, and the second contact surface 1103 of the heat dissipation component 110 is in contact with the second surface of the thermoelectric power generation sheet 160. In a working process, the heat absorption component 130 can absorb heat generated by a combustion heater, and the heat dissipation component 110 can dissipate heat. Therefore, the heat absorption component 130 and the heat dissipation component 110 can enable a temperature difference to be formed between the first surface and the second surface of the thermoelectric power generation sheet 160. The thermoelectric power generation sheet 160 is capable of generating electric power when the temperature difference is formed between the first surface and the second surface, and the electric power generated by the thermoelectric power generation sheet 160 can be provided for a heater appliance apparatus for use. The thermoelectric power generation sheet 160 can convert thermal energy generated by fuel, to implement self-sufficiency of electric power of a heater device, so that convenience of using the heater is greatly improved. In addition, in this embodiment, the heat absorption component 130 can absorb heat generated by combustion. Therefore, the heat absorption component 130 can further enable the temperature difference between the two surfaces of the thermoelectric power generation sheet 160 to be more obvious, and a power generation effect of the thermoelectric power generation sheet 160 is more significant.

In a further feasible manner of this embodiment, the heat absorption component 130 includes a heat absorption baseplate 1301 and heat absorption sheets 1302, the plurality of heat absorption sheets 1302 are disposed on a front surface of the heat absorption baseplate 1301, the first contact surface 1304 is a back surface of the heat absorption baseplate 1301, the heat dissipation component 110 includes a heat dissipation baseplate 1101 and heat dissipation sheets 1105, the plurality of heat dissipation sheets 1105 are uniformly disposed on a front surface of the heat dissipation baseplate 1101, and the second contact surface 1103 is formed on a back surface of the heat dissipation baseplate 1101.

In this embodiment, the heat absorption sheets 1302 are used to rapidly absorb heat, and the heat dissipation sheets 1105 can rapidly dissipate heat, so that the temperature difference can be rapidly formed between the two surfaces of the thermoelectric power generation sheet 160.

In a further feasible manner of this embodiment, downward recessed accommodating space 1102 is formed on the back surface of the heat dissipation baseplate 1101, a bottom surface of the accommodating space 1102 is the second contact surface 1103, the thermoelectric power generation sheet 160 is disposed in the accommodating space 1102, and two side surfaces of the thermoelectric power generation sheet 160 are respectively the first surface and the second surface.

In a further feasible manner of this embodiment, the second surface of the thermoelectric power generation sheet 160 protrudes from the accommodating space 1102, and is in contact with the back surface of the heat absorption baseplate 1301, and a first specified gap 150 is formed between the back surface of the heat absorption baseplate 1301 and the back surface of the heat dissipation baseplate 1101.

In this embodiment, the gap exists between the back surface of the heat absorption baseplate 1301 and the back surface of the heat dissipation baseplate 1101. The gap can ensure that the heat absorption baseplate 1301 is not in direct contact with the heat dissipation baseplate 1101, and can effectively prevent contact-type heat conduction from being performed between the heat absorption component 130 and the heat dissipation component 110.

In a further feasible manner of this embodiment, the thermoelectric power generation system further includes a pressing component 170 and a fixing plate 180, the pressing component 170 is pressed on the heat absorption component 130, the fixing plate 180 is pressed on the pressing component 170, a fastener is disposed on the pressing component 170, the fastener is threadedly connected to the heat dissipation baseplate 1101, and a second specified gap 140 exists between the fixing plate 180 and the back surface of the heat dissipation component 110.

In this embodiment, the gap exists between the fixing plate 180 and the back surface of the heat dissipation component 110. The gap can prevent heat transfer caused by contact between the pressing component 170 and the heat dissipation component 110.

The installation structure in this embodiment can ensure that the heat absorption component 130 and the heat dissipation component 110 are respectively in contact with the two surfaces of the thermoelectric power generation sheet 160 and that the heat absorption component 130 and the heat dissipation component 110 are not in direct contact with each other, and can further ensure that the heat absorption component 130, the heat dissipation component 110, and the thermoelectric power generation sheet 160 implement mutual positioning.

In this embodiment, a fixing plate opening 1801 is formed on the fixing plate 180, and the heat absorption sheets 1302 project from the fixing plate opening 1801.

In a further feasible manner of this embodiment, the plurality of heat absorption sheets 1302 are disposed in parallel, a heat absorption groove 1303 is formed between every two adjacent heat absorption sheets 1302, the pressing component 170 includes a pressing strip 1701 and a connecting end plate 1702, the pressing strip 1701 is located in the heat absorption groove 1303, the connecting end plate 1702 is connected to an end portion of the pressing strip 1701, and the fixing plate 180 is pressed on the connecting end plate 1702.

In a further feasible manner of this embodiment, the pressing strip 1701 is an elastic pressing strip.

In this embodiment, the pressing strip 1701 is disposed in the heat absorption groove 1303, so that it is convenient to install and position the pressing strip 1701. In addition, the pressing strip 1701 being an elastic pressing strip can make pressing positioning more stable.

In a further feasible manner of this embodiment, an installation opening is formed on the installation partition 120, a heat absorption channel is formed on one side of the installation partition 120, a heat dissipation channel is formed on the other side of the installation partition 120, the heat dissipation baseplate 1101 is fastened on the installation partition 120, the heat absorption sheets 1302 penetrate the installation opening, and extend into the heat absorption channel, and the heat dissipation sheets 1105 are located in the heat dissipation channel.

In a further feasible manner of this embodiment, a heat insulation component 190 is disposed between the fixing plate 180 and the back surface of the heat dissipation baseplate 1101, and a heat insulation component 190 is disposed between the fixing plate 180 and the installation partition 120 in this embodiment.

In a further feasible manner of this embodiment, a bracket component 1104 is disposed on the heat dissipation baseplate 1101, and the bracket component 1104 is fastened to the installation partition 120 by using a fastener.

In the descriptions of this specification, descriptions provided with reference to terms such as "an embodiment", "some embodiments", "an example", "a specific example", or "some examples" intend to mean that a specific feature, structure, material, or characteristic described with reference to the embodiment or example is included in at least one embodiment or example of the present invention. In addition, the described specific features, structures, materials, or characteristics can be properly combined in any one or more of the embodiments or examples. In addition, a person skilled in the art can integrate and combine different embodiments or examples and features in different embodiments or examples described in this specification, provided that the embodiments or the examples and the features do not conflict with each other.

In addition, terms "first" and "second" are used only for description purposes, and cannot be understood as an indication or an implication of relative importance or an implicit indication of a quantity of indicated technical features. Therefore, features defined with "first" or "second" may explicitly or implicitly include at least one of the features. In the descriptions of the present invention, "a plurality of' means two or more, unless otherwise specifically limited.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A thermoelectric power generation system, comprising:
a heat absorption component, configured to absorb heat, wherein at least a first contact surface is formed on the heat absorption component;
a heat dissipation component, configured to dissipate heat, wherein at least a second contact surface is formed on the heat dissipation component;
a thermoelectric power generation sheet, wherein the thermoelectric power generation sheet has at least a first surface and a second surface, the thermoelectric power generation sheet is capable of generating electric power based on at least a temperature difference between the first surface and the second surface, the first surface is in contact with the first contact surface of the heat absorption component, and the second surface is in contact with the second contact surface of the heat dissipation component; and
an installation partition, wherein the heat dissipation component is connected to the installation partition, the heat absorption component is connected to the heat dissipation component, the heat dissipation component is located on one side of the installation partition, and the heat absorption component is located on the other side of the installation partition.

2. The thermoelectric power generation system according to claim 1, wherein the heat absorption component comprises a heat absorption baseplate and heat absorption sheets, the plurality of heat absorption sheets are disposed on a front surface of the heat absorption baseplate, the first contact surface is a back surface of the heat absorption baseplate, the heat dissipation component comprises a heat dissipation baseplate and heat dissipation sheets, the plurality of heat dissipation sheets are uniformly disposed on a front surface of the heat dissipation baseplate, and the second contact surface is formed on a back surface of the heat dissipation baseplate.

3. The thermoelectric power generation system according to claim 2, wherein downward recessed accommodating space is formed on the back surface of the heat dissipation baseplate, a bottom surface of the accommodating space is the second contact surface, the thermoelectric power generation sheet is disposed in the accommodating space, and two side surfaces of the thermoelectric power generation sheet are respectively the first surface and the second surface.

4. The thermoelectric power generation system according to claim 3, wherein the second surface of the thermoelectric power generation sheet protrudes from the accommodating space, and is in contact with the back surface of the heat absorption baseplate, and a first specified gap is formed between the back surface of the heat absorption baseplate and the back surface of the heat dissipation baseplate.

5. The thermoelectric power generation system according to claim 4, wherein the thermoelectric power generation system further comprises a pressing component and a fixing plate, the pressing component is pressed on the heat absorption component, the fixing plate is pressed on the pressing component, a fastener is disposed on the pressing component, the fastener is threadedly connected to the heat dissipation baseplate, and a second specified gap exists between the fixing plate and the back surface of the heat dissipation component.

6. The thermoelectric power generation system according to claim 5, wherein the plurality of heat absorption sheets are disposed in parallel, a heat absorption groove is formed between every two adjacent heat absorption sheets, the pressing component comprises a pressing strip and a connecting end plate, the pressing strip is located in the heat absorption groove, the connecting end plate is connected to an end portion of the pressing strip, and the fixing plate is pressed on the connecting end plate.

7. The thermoelectric power generation system according to claim 6, wherein the pressing strip is an elastic pressing strip.

8. The thermoelectric power generation system according to any one of claims 2 to 7, wherein an installation opening is formed on the installation partition, a heat absorption channel is formed on one side of the installation partition, a heat dissipation channel is formed on the other side of the installation partition, the heat dissipation baseplate is fastened on the installation partition, the heat absorption sheets penetrate the installation opening, and extend into the heat absorption channel, and the heat dissipation sheets are located in the heat dissipation channel.

9. The thermoelectric power generation system according to claim 5, wherein a heat insulation component is disposed between the fixing plate and the back surface of the heat dissipation baseplate.

10. The thermoelectric power generation system according to claim 8, wherein a bracket component is disposed on the heat dissipation baseplate, and the bracket component is fastened to the installation partition by using a fastener.
